# FASCICULE DE BREVET EUROPEEN

(11) **EP 2 840 594 B1**
(45) Date de publication et mention de la délivrance du brevet: **22.06.2016**
(21) Numéro de dépôt: 14179982.5
(22) Date de dépôt: 06.08.2014
(51) Int. Cl.: H01L 21/336, H01L 29/786, H01L 21/265, H01L 29/10

(54) **Recristallisation de blocs de source et de drain par le haut**
Rekristallisierung von Source und Drain von oben
Recrystallisation of blocks with source and drain by the top

(30) Priorité: 09.08.2013 FR 1357929
(43) Date de publication de la demande: 25.02.2015
(73) Titulaire: Commissariat à l'Énergie Atomique et aux Énergies Alternatives, 75015 Paris (FR); STmicroelectronics SA, 92120 Montrouge (FR)
(72) Inventeur: Batude, Perrine, 21000 DIJON (FR); Mazen, Frédéric, 38100 GRENOBLE (FR); Sklenard, Benoît, 38000 GRENOBLE (FR); Reboh, Shay, Guilderland, NY 12084 (FR)
(74) Mandataire: Brevalex

(56) Documents cités:
- US-A1- 2009 087 971
- US-B1- 6 403 433

## Description

### DOMAINE TECHNIQUE ET ART ANTÉRIEUR

La présente invention se rapporte au domaine de la microélectronique et plus particulièrement à celui des procédés de fabrication de transistors.

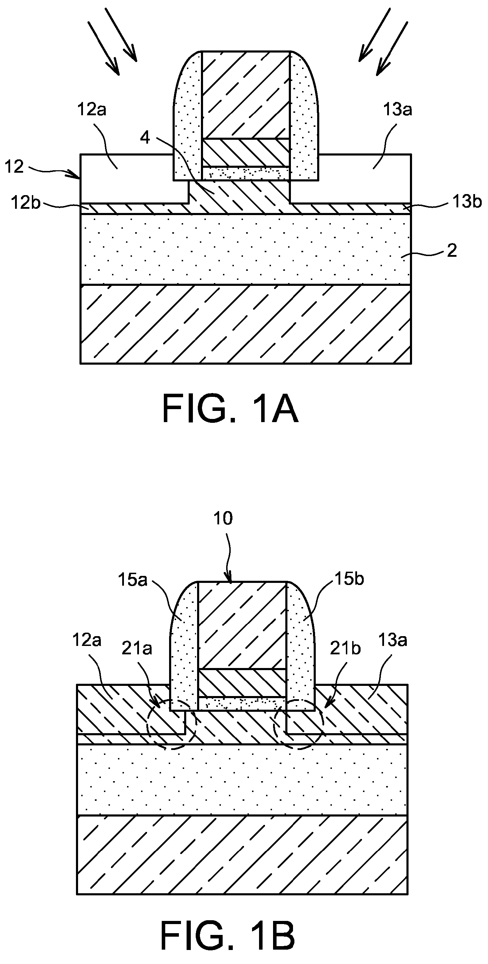

Afin d'améliorer les performances d'un transistor mis en oeuvre sur un substrat de type semi-conducteur sur isolant, par exemple de type SOI (SOI pour « silicon on insulator » ou « silicium sur isolant »), il est connu de réaliser des régions de source et de drain surélevées, c'est à dire qui sont réalisées au moins en partie dans des blocs semi-conducteurs 12, 13 (figure 1A) qui s'étendent de part et d'autre d'une grille 10, au-dessus d'une couche semi-conductrice superficielle 4 du substrat dans laquelle le canal du transistor est prévu.

Les blocs semi-conducteurs de source et de drain surélevés peuvent être ensuite dopés par implantation (figure 1A), cette implantation ayant tendance à détruire la structure cristalline du matériau semi-conducteur dopé et à le rendre amorphe. Une activation des dopants dans le matériau semi-conducteur amorphe peut être alors réalisée à basse température, en particulier comprise entre 400 °C et 600 °C (figure 1B).

Si l'on implante les régions de source et de drain sur toute leur épaisseur, c'est-à-dire jusqu'à une couche isolante 2 par exemple de type BOX (BOX pour « Burried Oxide ») du substrat semi-conducteur sur isolant, une recristallisation du matériau rendu amorphe sera difficile, voire impossible, à mettre en oeuvre.

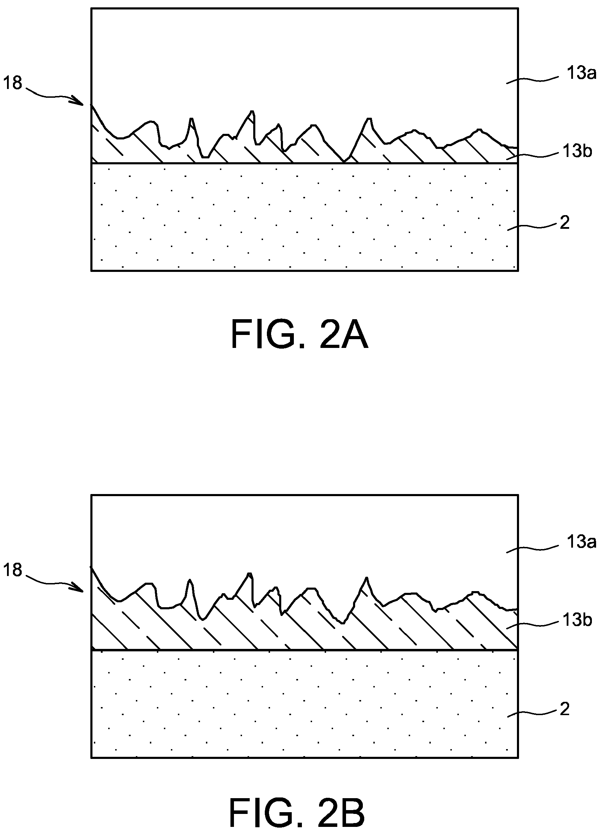

La figure 2A, illustre un cas dans lequel une implantation des blocs de source et de drain a été réalisée de telle sorte qu'une interface 18 entre une région 13a d'un bloc de source rendue amorphe par implantation et une zone 13b, située sous la région 13a de ce bloc de source, et dont la structure cristalline a été conservée et se trouve tellement proche de la couche isolante 2 d'un substrat de type SOI, qu'une recristallisation est difficile à réaliser.

Cette interface 18 n'étant pas parfaitement plane et difficile à maitriser précisément, on cherche généralement à la rehausser par rapport à la couche isolante 2 du substrat, en effectuant une implantation moins profonde (figure 2B).

Cependant, lorsqu'on rehausse l'interface 18 par rapport à la couche isolante 2 du substrat semi-conducteur sur isolant il s'avère délicat dans le même temps de pouvoir bien doper les régions proches du BOX et notamment des régions 21a, 21b situées de part et d'autre du canal, sous les espaceurs isolants 15a, 15b (figure 1B) particulièrement critiques pour les performances des transistors.

Le document US 2009/0087971 A1 présente un procédé de réalisation d'un transistor sur un substrat de type semi-conducteur sur isolant dans lequel on rend amorphe et on dope simultanément des blocs de source et de drain disposés de part et d'autre d'une zone puis on effectue un recuit de recristallisation et d'activation des dopants.

Il se pose donc le problème de trouver un nouveau procédé de réalisation d'un transistor ayant des résistances d'accès réduites et qui est amélioré vis-à-vis des inconvénients décrits ci-dessus.

### EXPOSÉ DE L'INVENTlON

La présente invention concerne, selon un mode de réalisation, un procédé de mise en oeuvre d'un transistor sur un substrat de type semi-conducteur sur isolant comprenant des étapes consistant à :
a) rendre amorphes et doper, à l'aide d'une ou plusieurs implantation(s) localisées, des régions données de blocs de matériau semi-conducteur cristallin reposant sur une couche isolante d'un substrat semi-conducteur sur isolant et destinés à former des blocs de source et de drain disposés de part et d'autre d'une zone dans laquelle un canal du transistor est destiné à être réalisé, la ou les implantations étant effectuée(s) de manière à conserver en surface desdits blocs une épaisseur de matériau semi-conducteur cristallin sur lesdites régions données de matériau semi-conducteur rendues amorphes,
b) recuit de recristallisation et d'activation des dopants d'au moins une portion desdites régions données.

Ainsi, en conservant en surface, une épaisseur de matériau semi-conducteur cristallin au-dessus des régions rendues amorphes des blocs semi-conducteurs de source et de drain, on peut par la suite recristalliser aisément ces régions.

La recristallisation se fait alors par le biais d'un front se dirigeant verticalement depuis l'épaisseur de matériau semi-conducteur cristallin conservée en surface vers la couche isolante du substrat semi-conducteur sur isolant.

Avec un tel procédé, la ou les implantations peuvent être mises en oeuvre avec des doses plus fortes et selon des inclinaisons plus importantes, car il ne nécessite pas obligatoirement de conserver une épaisseur importante de germe de matériau semi-conducteur cristallin à proximité de la couche isolante du substrat.

Ainsi, au moins une desdites implantations à l'étape a) peut être réalisée à l'aide d'un faisceau incliné par rapport à une normale au plan principal du substrat, de sorte que lesdites régions données de matériau semi-conducteur rendues amorphes et dopées, s'étendent sous des espaceurs isolants situés de part et d'autre d'une grille du transistor située en regard de ladite zone de canal.

Par rapport à un procédé suivant l'art antérieur dans lequel on effectuerait une amorphisation de la partie supérieure des blocs de source et de suivant l'art antérieur drain en gardant une partie inférieure cristalline, un tel procédé permet soit de réaliser une meilleure activation des dopants par rapport à un procédé dans lequel la partie inférieure cristalline conservée serait trop importante soit de mettre en oeuvre une meilleure recristallisation des régions rendues amorphes par rapport à un procédé dans lequel la partie inférieure cristalline conservée serait trop faible.

A l'étape a), l'amorphisation et le dopage sont réalisées par plusieurs étapes successives d'implantation. L'étape a) peut comprendre :
- une implantation à l'aide d'une espèce non dopante de manière à rendre amorphe au moins une portion desdites régions données,
- une implantation d'une espèce dopante donneuse ou accepteuse de manière à effectuer un dopage de type N ou de type P d'au moins une portion desdites régions données.

L'implantation par l'espèce dopante est réalisée à une température supérieure à une température critique et au-delà de laquelle quelle que soit la dose d'implantation de cette espèce dopante, le matériau semi-conducteur n'est pas rendu amorphe. Cette température critique dépend de l'espèce dopante implantée et du matériau semi-conducteur implantée.

On évite ainsi d'avoir à effectuer une nouvelle recristallisation.

En variante, à l'étape a), l'amorphisation et le dopage peuvent être réalisés par des étapes de :
- implantation d'une espèce dopante donneuse ou accepteuse de manière à effectuer un dopage de type N ou de type P d'au moins une portion desdites régions données,
- implantation à l'aide d'une espèce non dopante de manière à rendre amorphe au moins une portion desdites régions données.

De même, l'implantation par l'espèce dopante est réalisée à une température supérieure à une température critique et au-delà de laquelle quelle que soit la dose d'implantation de cette espèce dopante, le matériau semi-conducteur n'est pas rendu amorphe.

L'implantation par l'espèce dopante peut être suivie à l'étape b) par au moins un autre recuit de recristallisation.

Une implantation réalisée à une température supérieure à la température critique encore appelée dans la présente demande « implantation à chaud » permet également d'obtenir une répartition plus uniforme de dopants.

L'espèce non dopante utilisée pour l'amorphisation de la couche peut être par exemple des atomes de Si ou de Ge.

Selon une possibilité de mise en oeuvre du procédé, la ou les implantations à l'étape a) peuvent être réalisées de sorte que lesdites régions données de matériau semi-conducteur rendues amorphes peuvent être en contact avec la couche isolante du substrat.

A l'étape b) on peut avantageusement effectuer un recuit de recristallisation et d'activation des dopants à basse température, i.e. à une température inférieure à 600°C.

Le procédé suivant l'invention permet ainsi de s'adapter à des contraintes importantes en termes de budget thermique.

Selon une possibilité de mise en oeuvre du procédé, à l'étape a), on peut réaliser plusieurs implantations dont :
- au moins une première implantation d'espèce dopante à l'aide d'un faisceau incliné selon un premier angle α₁, tel que α₁ > 0, par rapport à une normale au plan principal du substrat,

Après l'étape b), on peut former des zones d'alliage de matériau semi-conducteur et de métal à partir desdites blocs semi-conducteurs.

Selon une possibilité de mise en oeuvre, ces zones d'alliage de matériau semi-conducteur et de métal peuvent être réalisées par :
- dépôt de matériau métallique sur l'épaisseur conservée de matériau semi-conducteur cristallin, puis
- recuit thermique, de sorte qu'au moins une portion des régions rendues amorphes à l'étape a) est transformée en alliage de matériau semi-conducteur et de métal.

Selon une possibilité de mise en oeuvre du procédé les blocs de matériau semi-conducteur sont formés d'une première couche à base de Siₓ₁Ge_{y1}, surmontée d'une deuxième couche à base de Siₓ₂Ge_{y2}. Avec 0<y₂<y₁

Dans ce cas l'interface entre le matériau semi-conducteur cristallin et les régions rendues amorphes est précisément défini et se situe au niveau de l'interface entre la première couche à base de Siₓ₁Ge_{y1}, et la deuxième couche à base de Siₓ₂Ge_{y2}.

Selon un mode de réalisation, l'invention concerne un transistor sur un substrat de type semi-conducteur sur isolant comprenant des régions de blocs de matériau semi-conducteur reposant sur une couche isolante du substrat semi-conducteur sur isolant et destinés à former des blocs de source et de drain disposés de part et d'autre d'une zone dans laquelle un canal du transistor est destiné à être réalisé, avec en surface des blocs, une épaisseur de matériau semi-conducteur cristallin sur des régions données de matériau semi-conducteur amorphes, les blocs de matériau semi-conducteur étant formées d'une première couche à base de Siₓ₁Ge_{y1}, surmontée d'une deuxième couche à base de Siₓ₂Ge_{y2}, avec 0 ≤ y₂ < y₁, une interface entre le matériau semi-conducteur cristallin et les régions amorphes étant située au niveau d'une interface entre la première couche à base de Siₓ₁Ge_{y1}, et la deuxième couche à base de Siₓ₂Ge_{y2}. régions amorphes étant située au niveau d'une interface entre la première couche à base de Siₓ₁Ge_{y1}, et la deuxième couche à base de Siₓ₂Ge_{y2}.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1B illustrent une réalisation, suivant l'art antérieur, de blocs de source et de drain d'un transistor MOS,
- les figures 2A-2B illustrent, dans une région de source d'un transistor qui a été implantée, une interface entre une zone rendue amorphe par cette implantation et une zone dont la structure cristalline n'a pas été impactée par l'implantation,

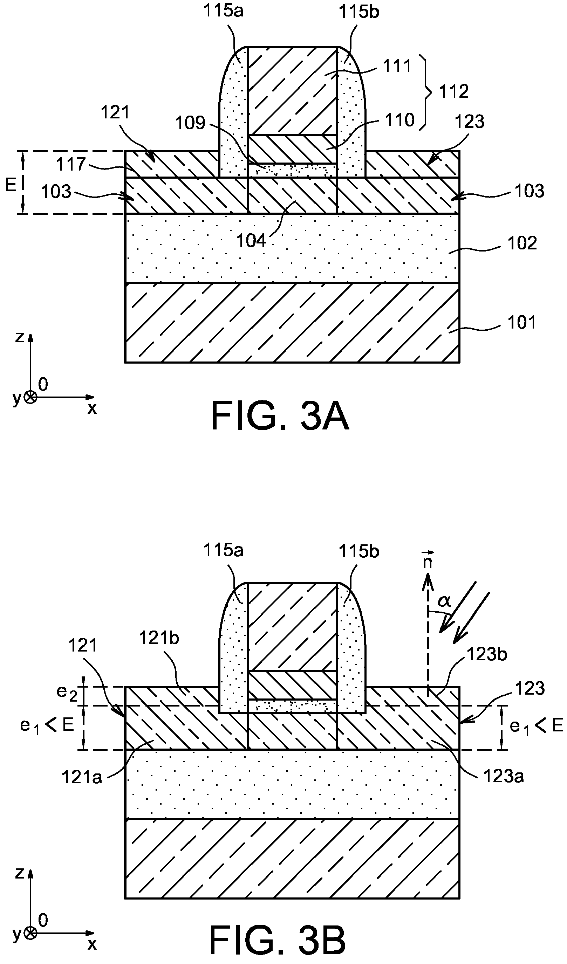

- les figures 3A-3E illustrent un premier exemple de procédé, de mise en oeuvre d'un transistor dans lequel on réalise une amorphisation enterrée de blocs semi-conducteurs de source et de drain tout en conservant une zone superficielle dont la structure cristalline n'a pas été impactée par l'implantation amorphisante,

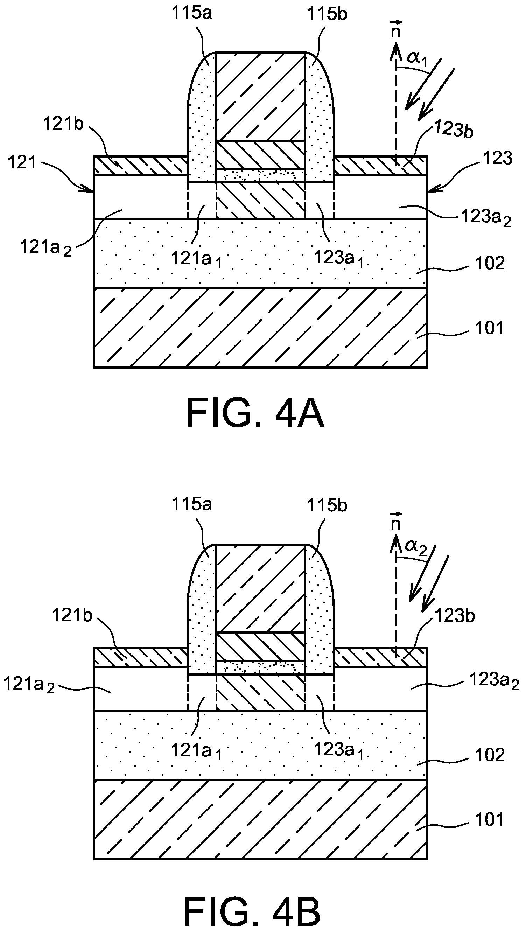

- les figures 4A-4D illustrent une variante du premier exemple procédé de mise en oeuvre d'un transistor, dans laquelle on réalise plusieurs implantations selon des angles d'inclinaison différents afin de rendre amorphe et doper différentes régions de blocs semi-conducteurs de source et de drain, tout en conservant une épaisseur dont la structure cristalline n'a pas été impactée par l'implantation au-dessus des régions rendues amorphes et dopées,

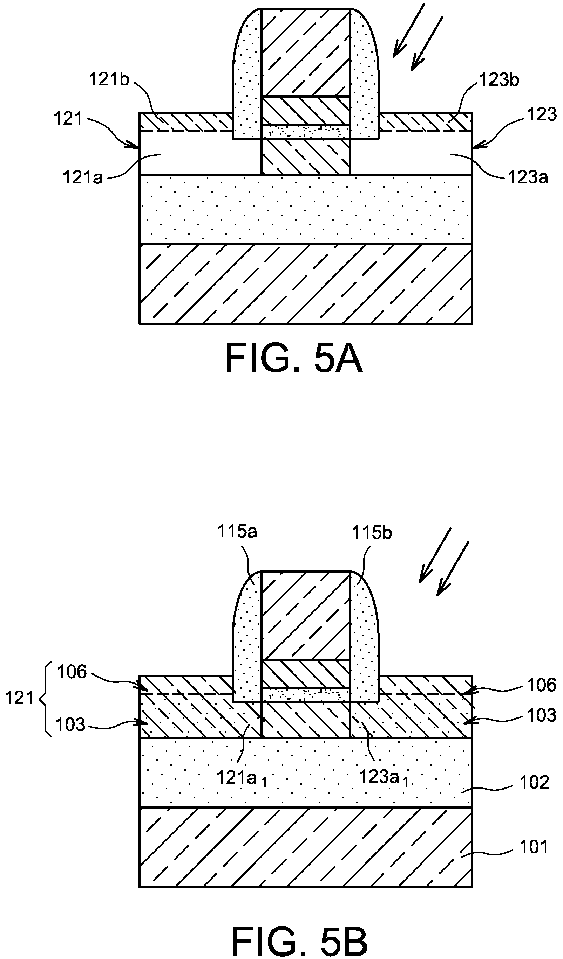

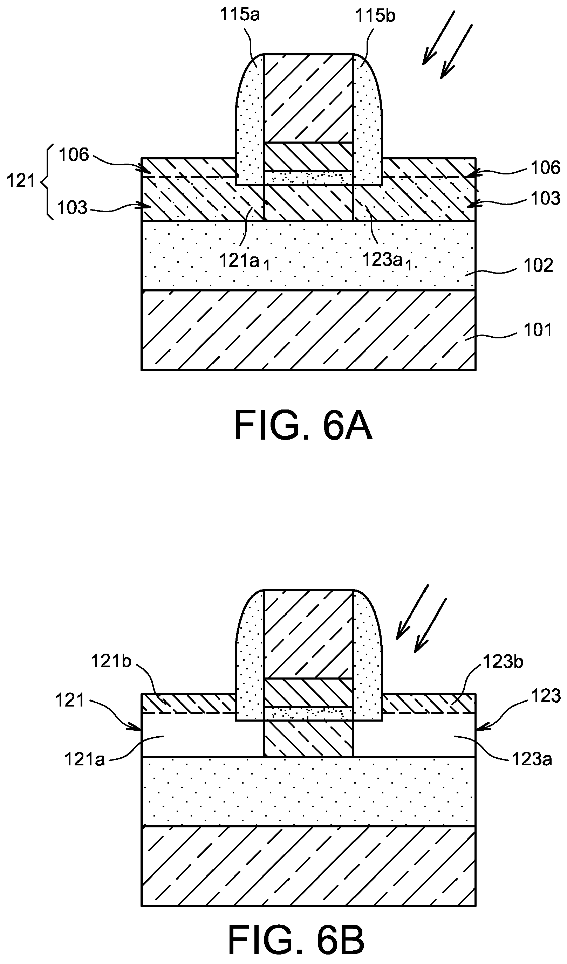

- les figures 5A-5B et 6A-6B, illustrent une variante de procédé de réalisation de transistor, mise en oeuvre selon un mode de réalisation de la présente invention, et dans laquelle des étapes d'amorphisation de régions enfouies des blocs semi-conducteurs de source et de drain et de dopage de type N ou P sont dissociées,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de procédé de réalisation d'un transistor, va à présent être décrit en liaison avec les figures 3A-3E.

Le matériau de départ de cet exemple de procédé peut être un substrat de type semi-conducteur sur isolant, par exemple de type SOI, qui comprend une couche de support 101 semi-conductrice, une couche isolante 102 qui peut être à base d'oxyde de silicium et est disposée sur et en contact avec la couche de support 101.

La couche isolante 102 du substrat peut être en particulier une couche de type BOX (BOX pour « Burried Oxide ») ou TBOX (TBOX pour « Thin Burried Oxide ») d'épaisseur par exemple de l'ordre 20 nm.

Le substrat comporte également une fine couche semi conductrice 103 à base de matériau cristallin située sur, et en contact avec, ladite couche isolante 102. La fine couche semi-conductrice 103 peut être par exemple à base de Si et d'épaisseur comprise par exemple entre 3 et 50nm, par exemple de l'ordre 6 nm.

Des étapes de dépôt d'une couche de diélectrique 109 de grille et d'une ou plusieurs couches 110, 111 de matériau(x) de grille, puis de gravure de ces couches afin de réaliser un motif de grille 112 en regard d'une zone 104 de la fine couche semi-conductrice 103 destinée à former un canal pour le transistor, sont effectuées. La grille 112 du transistor peut être formée d'un empilement comprenant une couche métallique 110, par exemple à base de TiN, sur laquelle repose une couche semi-conductrice 111, par exemple à base de polysilicium.

Des espaceurs isolants 115a, 115b, par exemple à base de SiₓN_{y} sont également formés contre les flancs latéraux de la grille 112, et reposent sur la fine couche semi-conductrice 103.

Puis, on fait croitre du matériau semi-conducteur cristallin 117 par épitaxie sur la fine couche semi-conductrice 103, afin de former avec cette fine couche semi-conductrice 103, des blocs 121, 123 semi-conducteurs destinés à former des régions de source et de drain surélevées et à base de matériau semi-conducteur cristallin disposées de part et d'autre de la zone 104 de canal et des espaceurs 115a, 115b. L'épaisseur de matériau semi-conducteur 117 que l'on fait croitre peut être par exemple de l'ordre de 16 nm.

Par « surélevé(e)s » on entend que les blocs 121, 123, qui, comme la zone 104 de canal, reposent sur la couche isolante 102, s'étendent au-dessus de la fine couche semi-conductrice 103 et ont ainsi une épaisseur supérieure à celle de la zone 104 de canal. L'épaisseur E (mesurée dans la direction de l'axe z du repère orthogonal [O,x,y,z]) des blocs 121, 123 peut être par exemple de l'ordre de 22 nm (figure 3A).

Ensuite, on réalise une amorphisation localisée de régions 121a, 123a des blocs semi-conducteurs 121, 123. On effectue en particulier une amorphisation dite « enterrée », de sorte que les régions 121a, 123a des blocs 121, 123 que l'on rend amorphes sont situées sous des zones 121b, 123b des blocs 121, 123 situées en surface et dont la structure cristalline est conservée. Les régions rendues amorphes peuvent s'étendre jusqu'à la couche isolante 102.

L'amorphisation enterrée peut être réalisée par exemple selon des conditions telles que décrites dans le document Signamarcheix T. et al., « Fully depleted silicon on insulator MOSFETs on (110) surface for hybrid orientation technologies » Solid-State Electronics Volume 59, Issue 1, May 2011.

L'amorphisation peut être effectuée à l'aide d'au moins une étape d'implantation (figure 3B).

Dans cet exemple de réalisation, l'implantation amorphisante du matériau semi-conducteur des régions semi-conductrices 121a, 123a est mise en oeuvre à l'aide d'une espèce dopante donneuse d'électrons permettant d'effectuer en outre un dopage de type N, ou à l'aide d'une espèce dopante accepteuse d'électrons permettant d'effectuer un dopage de type P.

Cette implantation est également effectuée de manière à doper des parties des régions semi-conductrices 121b, 123b situées sous les espaceurs 115a, 115b, de part et d'autre de la zone 104 de canal.

Ainsi, en même temps qu'on rend les rend amorphes, on dope des régions d'accès au canal.

Pour réaliser cela, on peut mettre en oeuvre une implantation au moyen d'un faisceau incliné réalisant un angle non-nul, par rapport à une normale n au plan principal du substrat (le plan principal du substrat étant un plan défini par un plan passant par ce dernier et parallèle au plan [O,x,y]).

Une implantation selon une forte dose, par exemple comprise entre 5^{e}14 et 4^{e}15, et un angle, par exemple compris entre 10° et 60° permet de d'atteindre et de doper les régions situées sous les espaceurs 115a, 115b à proximité de la zone de canal 104.

A l'issue de l'implantation ou des implantations, les régions 121a, 123a rendues amorphes s'étendent, dans une direction verticale, de la face supérieure de la couche isolante 102, jusqu'à une hauteur donnée égale à e₁ et qui est inférieure à l'épaisseur E des blocs semi-conducteurs 121, 123, les régions 121a, 123a étant surmontées et en contact de zones 121b, 123b de matériau semi-conducteur cristallin appartenant aux blocs semi-conducteurs 121, 123, et dont la structure cristalline n'a pas été impactée par la ou les implantations.

Les régions 121a, 123a rendues amorphes sont également disposées contre et en contact de la zone 104 de canal à base de matériau semi-conducteur cristallin. Les régions 121a, 123a rendues amorphes peuvent avoir une épaisseur e₁ < E, par exemple de l'ordre de 12 nm.

Les zones 121b, 123b superficielles à base de matériau semi-conducteur cristallin, et qui sont situées au-dessus des régions 121a, 123a, peuvent avoir, une épaisseur e₂ < E par exemple de l'ordre de 10 nm.

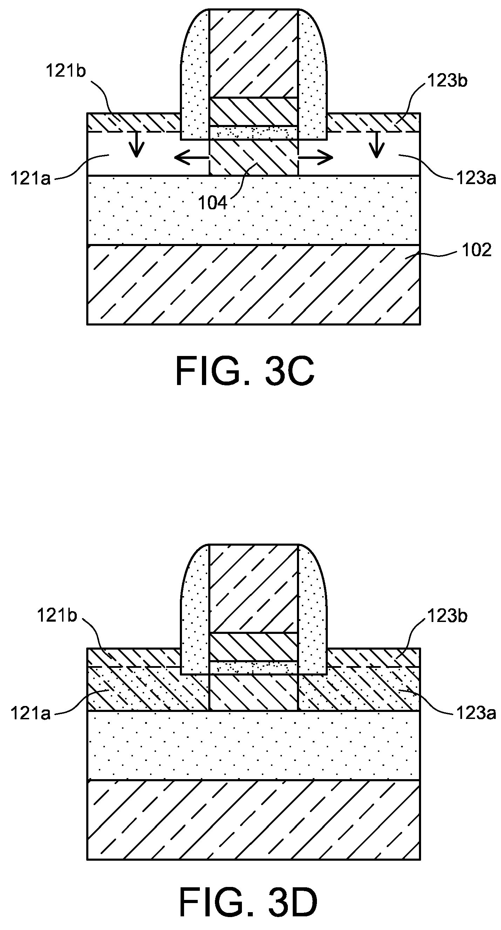

On effectue ensuite au moins un recuit thermique de recristallisation et d'activation des dopants (figure 3C).

Ce recuit est ainsi réalisé à une température choisie de manière à permettre d'effectuer à la fois une recristallisation et une activation des dopants. La température de recuit peut être une température basse, i.e. inférieure à 600°C, et comprise par exemple entre 400°C et 600°C. Les faces des zones 121b, 123b de matériau semi-conducteur cristallin surmontant les régions 121a, 123a, servent de départ à un front de recristallisation qui se déplace dans une direction verticale (i.e. parallèle à la direction définie par l'axe z du repère [O,x,y,z]), vers de la couche isolante 102.

Les faces latérales de la zone 104 de canal en contact avec les régions 121a, 123a, servent de départ à un autre front de recristallisation qui se déplace dans une direction horizontale (i.e. une direction parallèle au plan [O,x,y]). Le front de recristallisation vertical et le front de recristallisation horizontal sont destinés à se croiser.

A l'issue du recuit, les régions 121a, 123a peuvent être entièrement dopées, et en particulier dans des parties situées sous les espaceurs 115a, 115b (figure 3D).

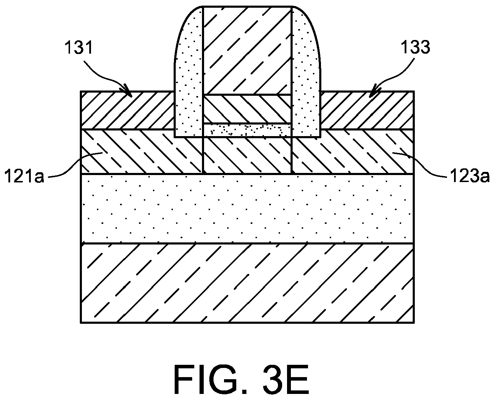

Ensuite (figure 3E), on forme des zones 131, 133 d'alliage de semi-conducteur et de métal à partir des blocs semi-conducteurs 121, 123. Cela peut être réalisé par dépôt d'une couche à base de matériau métallique, tel que par exemple du Ni ou du NiPt ou du Ti sur les zones semi-conductrices 121b, 123b puis par recuit thermique. Une siliciuration des zones 121b, 123b de matériau semi-conducteur cristallin gardées intactes lors de l'étape d'amorphisation précédemment décrite en liaison avec la figure 3B, et d'une portion des régions 121a, 123a rendues amorphes puis recristallisées permet de réduire les résistances de contact.

Selon une variante de réalisation de l'exemple qui vient d'être décrit, on peut remplacer l'étape d'implantation telle qu'illustrée sur la figure 3B, par plusieurs implantations (figures 4A-4C) afin d'établir plusieurs niveaux de dopages différents dans des parties différentes des blocs semi-conducteurs 121, 123 de source et de drain.

Ainsi, on peut tout d'abord réaliser une première implantation (figure 4A) au moyen d'un faisceau incliné réalisant un premier angle α₁, non-nul par rapport à une normale n au plan principal du substrat, par exemple compris entre 10° et 60°, de manière à pouvoir doper des portions 121a1, 123a1 des régions 121a, 123a situées sous les espaceurs 115a, 115b, de part et d'autre de la zone 104 de canal. Lors de cette première implantation, d'autres portions 121a2, 123a2 des régions 121a, 123a situées autour ou de part et d'autre des portions 121a1, 123a1 sont également dopées.

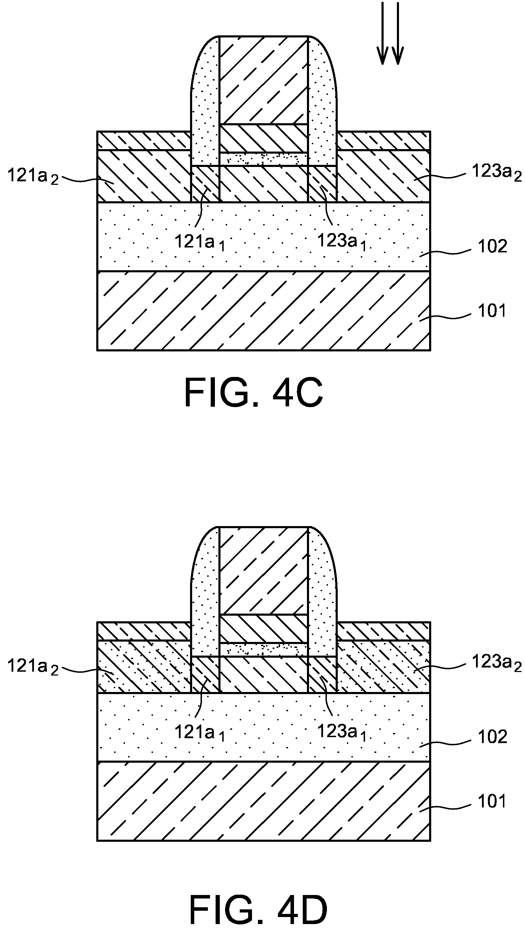

Puis, on effectue au moins une deuxième implantation au moyen d'un faisceau qui peut être incliné selon un angle α₂, par exemple inférieur à 30°, plus faible que pour la première implantation (figure 4B), ou bien au moyen d'un faisceau vertical c'est à dire cette fois parallèle à une normale n au plan principal du substrat (figure 4C). Cette deuxième implantation peut permettre de doper spécifiquement lesdites autres portions 121a2, 123a2 sans doper celles 121a1, 123a1 situées sous les espaceurs 115a, 115b.

On peut ainsi former dans les blocs semi-conducteurs 121, 123 des portions 121a2, 123a2 fortement dopées, tandis que les portions 121a1, 123a1 situées sous les espaceurs 115a, 115b, sont faiblement dopées ou plus faiblement dopées (figure 4D).

On peut réaliser ainsi un transistor comportant des régions de source et de drain dotées d'une portion fortement dopée (HDD ou « heavily doped source/drain » selon la terminologie anglo-saxonne) et d'une portion faiblement dopée (LDD ou « low doped source/drain » selon la terminologie anglo-saxonne).

Selon une variante avantageuse des exemples de réalisation qui viennent décrits, on dissocie les étapes d'amorphisation et de dopage des régions semi-conductrices 121a, 123a.

Un premier exemple de réalisation dans lequel les étapes d'amorphisation et de dopage de type N et/ou P sont dissociées, est illustré sur les figures 5A-5B.

Dans cet exemple, après avoir formé les blocs semi-conducteurs 121, 123, on peut tout d'abord réaliser une amorphisation des régions 121a, 123a semi-conductrices à l'aide d'une implantation (figure 5A).

On implante une espèce prévue spécifiquement prévue pour rendre amorphe le matériau semi-conducteur cristallin des régions 121a, 123a amorphes, sans réaliser un dopage de type N ou P. L'espèce implantée peut être à base d'atomes d'un élément non dopant tel que par exemple du Si ou du Ge.

L'amorphisation des blocs 121, 123 est réalisée de telle sorte qu'une épaisseur superficielle de matériau semi-conducteur cristallin est conservée au-dessus des régions 121a, 123a implantées.

On effectue ensuite une autre implantation afin de réaliser un dopage de type N ou de type P, du matériau semi-conducteur des régions semi-conductrices 121a, 123a, les zones 121b, 123b n'étant pas dopées.

Ce dopage peut être réalisé à chaud afin d'empêcher une amorphisation non désirée de certaines zones semi-conductrices, et en particulier des zones 121b, 123b. Un dopage à chaud permet d'utiliser des énergies d'implantation importantes et par conséquent d'obtenir un profil de dopage plus uniforme sans amorphiser complètement le film. Par dopage à chaud, on entend que l'implantation est réalisée à une température supérieure à une température critique T*_{C}* au-delà de laquelle le matériau semi-conducteur des blocs 121, 123 de la couche semi-conductrice ne peut être rendu amorphe.

Une température critique T_{C} = T_{∞} pour laquelle on n'amorphise pas quelle que soit la dose est exposée par exemple dans le document « A model for the formation of amorphous Si by ion bombardment, Radiation Effects : Incorporating Plasma Science and Plasma Technology », de Morehead et al., 1970, 6:1, 27-32.

Le choix de cette température pour l'Homme du Métier dépend notamment du matériau semi-conducteur implanté et de l'espèce utilisée pour mettre en oeuvre cette implantation. La température critique T_{C} dépend également de la concentration de dopants implantée.

La température critique Tc est par exemple de l'ordre de 400K dans le cas où le matériau semi-conducteur dopé est du silicium et le dopage est réalisé au Phosphore avec une dose par exemple comprise entre 1 et 2^{e}15 at/cm².

Un autre exemple de réalisation illustré sur les figures 6A-6B prévoit d'inverser les étapes de dopage et d'amorphisation.

On réalise ainsi tout d'abord une première implantation pour réaliser un dopage de type N ou de type P (figure 6A). L'implantation est réalisée à une température supérieure à la température critique T_{C} au-delà de laquelle le matériau semi-conducteur des blocs 121, 123 de la couche semi-conductrice ne peut être rendu amorphe.

On effectue ensuite une deuxième implantation, pour rendre amorphes des régions 121a, 123a des blocs semi-conducteurs (figure 6B).

Cette deuxième implantation peut être alors suivie d'un recuit, de recristallisation, par exemple à une température comprise entre 400°C et 600°C, afin de restaurer la structure cristalline des régions 121a, 123a.

L'implantation à chaud permet de positionner des concentrations de dopants importantes dans le fond de zones d'accès du transistor.

Par exemple dans le cas où l'on implante un dopant lourd comme l'arsenic, une concentration maximale qui permettrait de laisser une couche cristalline de 3 nm au fond d'un accès de 20 nm peut être de l'ordre de 1^{e}19 atomes/cm³.

Avec le présent procédé utilisant l'implantation à chaud, en dimensionnant bien les conditions d'implantation en particulier la température, la dose, l'énergie, le débit de dose, il est possible d'atteindre des concentrations de dopants de l'ordre de 1^{e}20 atomes/cm³ à l'interface avec la couche isolante 102 de BOX. Un outil de simulation par exemple de type « Kinetic Monte Carlo » (KMC) en particulier tel que développé par la société Synopsys peut permettre d'aider l'Homme du Métier à dimensionner les paramètres d'implantation à chaud.

L'implantation à chaud permet également d'utiliser des énergies plus importantes sans amorphiser toute l'épaisseur de matériau semi-conducteur. Cela permet également d'éviter d'avoir des régions avec pics de concentrations trop important. On évite ainsi de se retrouver dans une gamme de concentration de dopants où ceux-ci sont susceptibles de former des amas de dopants encore appelés « clusters ».

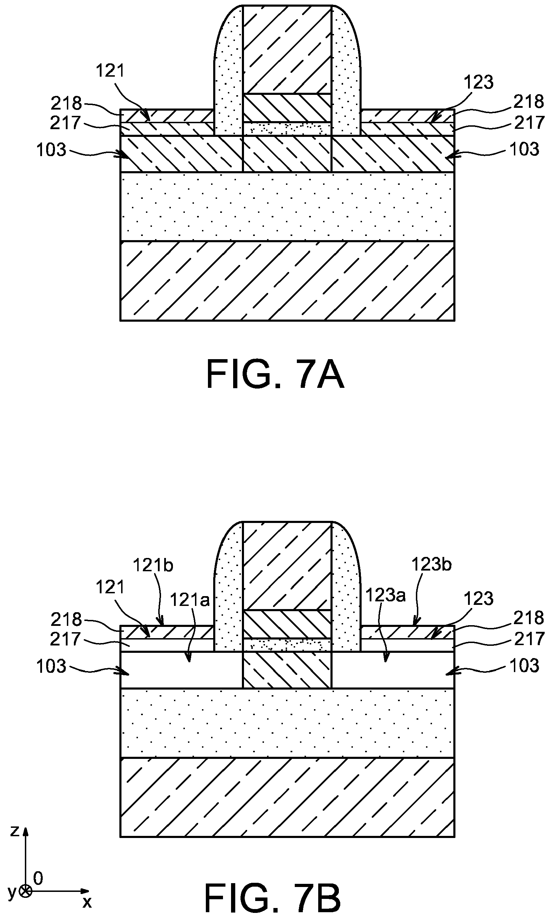

Une variante de réalisation du procédé est illustrée sur les figures 7A-7B.

Elle prévoit des blocs 121, 123 semi-conducteurs destinés à former des régions de source et de drain surélevées à base de matériaux semi-conducteurs différents.

Pour cela, on fait croitre par épitaxie sur la fine couche semi-conductrice 103 une première couche d'un matériau semi-conducteur cristallin 217 ayant un paramètre de maille différent de celui de la fine couche semi-conductrice 103. Lorsque la fine couche semi-conductrice 103 est à base de Si, le matériau semi-conducteur cristallin 217 peut être par exemple à base de Siₓ₁Ge_{y1}.

Puis, on fait croitre par épitaxie sur le matériau semi-conducteur cristallin 217 une deuxième couche d'un autre matériau semi-conducteur cristallin 218 ayant un paramètre de maille différent de celui du matériau 217. L'autre matériau semi-conducteur cristallin 218 peut être par exemple à base de Siₓ₂Ge_{y2}, avec 0 ≤ y₂ < y₁ (figure 7A).

Ensuite, on réalise l'amorphisation localisée de régions des blocs semi-conducteurs 121, 123 (figure 7B).

Le fait de prévoir un empilement de matériaux semi-conducteurs 217, 218 différents permet de localiser très précisément la zone amorphisée et donc l'interface entre la zone amorphisée et la zone cristalline.

La différence de concentration en Ge entre les deux couches de matériaux 217, 218 est choisie de sorte que, outre l'amorphisation de zones de la couche 103 qui peut être à base Si, seule la couche de matériau 217, dans cet exemple à base Siₓ₁Ge_{y1} "riche en Ge" ou plus "riche en Ge", est amorphisée.

La couche de matériau 218, dans cet exemple à base de Siₓ₂Ge_{y2} appartient alors à la zone laissée cristalline 121b, 123b et la couche Siₓ₁Ge_{y1} appartient à la zone amorphe 121a, 123a. Il est donc possible de réaliser une amorphisation sélective en choisissant y₁, y₂, la dose et la température d'implantation.

Ainsi l'interface entre la zone amorphisée et la zone restée cristalline est définie dans cet exemple par la concentration de Ge et correspond à l'interface des deux couches de matériau 217, 218. Cette interface est alors très précisément localisée et peut présenter une rugosité réduite.

Cette sélectivité dans l'amorphisation est par exemple décrite dans le document« Amorphization threshold in Si implated strained SiGe alloy layers » T.W. Simpson et al. EMRS nov 94.

Par exemple, la différence entre la concentration en Ge de la zone inférieure et la zone supérieure est de 5%. Dans un cas par exemple où l'on réalise un transistor de type PMOS, la zone inférieure peut être par exemple telle que y₁=30 % tandis que la zone supérieure peut être telle que y₂=20 %. Dans le cas par exemple où l'on réalise un transistor de type NMOS, la zone inférieure peut être par exemple telle que y₁ compris entre 5 % et 10 % tandis que la zone supérieure peut être telle que y₂= 0 %.

L'homme du métier saura obtenir les courbes expérimentales pour déterminer la différence de concentration en Ge, en fonction de la valeur de la dose et de la température pour obtenir une amorphisation sélective.

On effectue ensuite une implantation à chaud afin de réaliser un dopage de type N ou de type P, du matériau semi-conducteur des régions semi-conductrices 121a, 123a.

L'un ou l'autre des procédés qui viennent d'être décrits s'appliquent par exemple à la réalisation de transistors de type FDSOI (FDSOI pour « Fully Depleted Silicon On Insulator »), et en particulier à une fabrication de transistors utilisant un faible budget thermique, par exemple inférieur à 600°C.

## Revendications

1. Procédé de réalisation d'un transistor sur un substrat de type semi-conducteur sur isolant comprenant des étapes consistant à :
a) rendre amorphes et doper, à l'aide d'une ou plusieurs implantation(s) localisées, des régions (121a, 123a) de blocs (121, 123) de matériau semi-conducteur cristallin reposant sur une couche isolante (102) du substrat semi-conducteur sur isolant et destinés à former des blocs de source et de drain disposés de part et d'autre d'une zone (104) dans laquelle un canal du transistor est destiné à être réalisé, la ou les implantations étant réalisée(s) de manière à conserver en surface desdits blocs (121, 123) une épaisseur de matériau semi-conducteur cristallin sur lesdites régions données de matériau semi-conducteur rendues amorphes, l'amorphisation et le dopage étant réalisés à l'étape a) par plus d'une étape d'implantation comprenant dans cet ordre ou dans l'ordre inverse :
- une implantation à l'aide d'une espèce non dopante de manière à rendre amorphe au moins une portion desdites régions données (121a, 123a),
- une autre implantation d'une espèce dopante de manière à effectuer un dopage de type N ou de type P d'au moins une portion desdites régions données, cette autre implantation étant réalisée à une température supérieure à une température critique au-delà de laquelle ladite portion n'est pas rendue amorphe par cette autre implantation,
b) recuit de recristallisation et d'activation des dopants d'au moins une portion desdites régions données (121a, 123a).

2. Procédé selon la revendication 1, dans lequel au moins une desdites implantations à l'étape a) est réalisée à l'aide d'un faisceau incliné par rapport à une normale au plan principal du substrat, de sorte que lesdites régions de matériau semi-conducteur (121a, 123a) rendues amorphes et dopées, s'étendent sous des espaceurs isolants (115a, 115b) situés de part et d'autre d'une grille (112) du transistor située en regard de la zone de canal.

3. Procédé selon l'une des revendications 1 ou 2, dans lequel à l'étape b) on effectue un recuit de recristallisation et d'activation des dopants à une température inférieure à 600°C.

4. Procédé selon l'une des revendications 1 à 3, dans lequel, à l'étape a), on réalise plusieurs implantations dont :
- au moins une première implantation d'espèce dopante à l'aide d'un faisceau incliné selon un premier angle α₁, tel que α₁ > 0, par rapport à une normale au plan principal du substrat,
- au moins une deuxième implantation à l'aide d'un faisceau vertical ou incliné selon un deuxième angle α₂, tel que 0 < α₂ ≤ α₁ par rapport à une normale au plan principal du substrat.

5. Procédé de réalisation d'un transistor selon l'une des revendications 1 à 4, comprenant en outre, après l'étape b) : la formation de zones d'alliage (131, 133) de matériau semi-conducteur et de métal à partir desdites blocs semi-conducteurs par :
- dépôt de matériau métallique sur l'épaisseur conservée de matériau semi-conducteur cristallin, puis
- recuit thermique, au moins une portion des régions rendues amorphes à l'étape a) étant transformée en alliage de matériau semi-conducteur et de métal.

6. Procédé de réalisation d'un transistor selon l'une des revendications 1 à 5, dans lequel les blocs (121, 123) de matériau semi-conducteur sont formées d'une première couche à base de Siₓ₁Ge_{y1}, surmontée d'une deuxième couche à base de Siₓ₂Ge_{y2}, avec 0 ≤ y₂ < y₁ l'amorphisation à l'étape a) étant réalisée de sorte qu'une interface entre le matériau semi-conducteur cristallin et les régions rendues amorphes est située au niveau d'une interface entre la première couche à base de Siₓ₁Ge_{y1}, et la deuxième couche à base de Siₓ₂Ge_{y2.}

## Patentansprüche

1. Verfahren zur Herstellung eines Transistors auf einem Substrat vom Typ einem Halbleiter-auf-Isolator, das die folgenden Schritte umfasst:
a) Amorph machen und Dotieren mittels einer oder mehrerer lokalisierter Implantation(en) von Bereichen (121 a, 123a) von Blöcken (121, 123) aus kristallinem Halbleitermaterial, die auf einer Isolierschicht (102) des Halbleiter-auf-Isolator-Substrats aufliegen, und dazu bestimmt sind, Source und Drain Blöcke zu bilden, die beiderseits einer Zone (104) angeordnet sind, in der ein Transistorkanal hergestellt werden soll, wobei die Implantation(en) so durchgeführt wird/werden, dass an der Oberfläche der Blöcke (121, 123) eine Dicke von kristallinem Halbleitermaterial auf den gegebenen Bereichen von amorph gewordenem Halbleitermaterial zu bewahren, wobei die Amorphisierung und die Dotierung in Schritt a) mittels mehr als eines Implantationsschritts realisiert werden, umfassend in dieser oder in umgekehrter Reihenfolge:
- eine Implantation mit einer nicht dotierenden Spezies um mindestens einen Teil der gegebenen Bereiche (121 a, 123a) amorph zu machen,
- eine weitere Implantation mit einer dotierenden Spezies um eine N-Dotierung oder P-Dotierung mindestens eines Teils der gegebenen Bereiche auszuführen, wobei diese weitere Implantation bei einer Temperatur oberhalb einer kritischen Temperatur realisiert wird, über dieser Teil durch diese weitere Implantation nicht amorph wird,
b) Rekristallisierendes und aktivierendes Glühen von Dotierstoffen mindestens eines Teils der gegebenen Bereiche (121 a, 123a).

2. Verfahren nach Anspruch 1, worin mindestens eine der Implantationen in Schritt a) mit einem in bezug auf eine Normale zur Hauptebene des Substrats geneigten Strahl
realisiert wird, so dass die Bereiche aus Halbleitermaterial (121 a, 123a), die amorph gemacht und dotiert werden, sich unter isolierenden Abstandshaltern (115a, 115b) erstrecken, die sich beiderseits eines Transistorsgates (112) befinden, das sich gegenüber der Kanalzone befindet.

3. Verfahren nach einem der Ansprüche 1 oder 2, worin in Schritt b) ein rekristallisierendes und aktivierendes Glühen von Dotierstoffen bei einer Temperatur von weniger als 600°C durchgeführt wird.

4. Verfahren nach einem der Ansprüche 1 bis 3, worin in Schritt a), mehrere Implantationen realisiert werden, wobei:
- mindestens eine erste Implantation mit dotierender Spezies mittels eines in bezug auf eine Normale zur Hauptebene des Substrats um einen ersten Winkel α₁ mit α₁>0 geneigten Strahls,
- mindestens eine zweite Implantation mittels eines vertikalen oder um einen zweiten Winkel α₂ mit 0<α₂<α₁ in bezug auf eine Normale zur Hauptebene des Substrats geneigten Strahls.

5. Verfahren zur Herstellung eines Transistors nach einem der Ansprüche 1 bis 4, weiterhin umfassend nach dem Schritt b): die Ausbildung von Legierungszonen (131, 133) aus Halbleitermaterial und Metal ausgehend von den Halbleiterblöcken durch:
- Abscheidung von metallischem Material auf die bewahrte Dicke von kristallinem Halbleitermaterial, dann
- Thermisches Glühen, wobei mindestens ein Teil der in Schritt a) amorph gemachten Bereiche, in eine Legierung aus Halbleitermaterial und Metal umgewandelt wird.

6. Verfahren zur Herstellung eines Transistors nach einem der Ansprüche 1 bis 5, worin die Blöcke (121, 123) aus Halbleitermaterial aus einer ersten Schicht auf Basis von Siₓ₁Ge_{y1} gebildet sind, auf der eine zweite Schicht auf Basis von Siₓ₂Ge_{y2} mit 0≤y₂<y₁ angordnet ist, wobei die Amorphisierung in Schritt a) so realisiert wird, dass sich eine Schnittstelle zwischen dem kristallinen Halbleitermaterial und den amorph gemachten Bereichen auf der Ebene einer Schnittstelle zwischen der ersten Schicht auf Basis von Siₓ₁Ge y₁ und der zweiten Schicht auf Basis von Siₓ₂Ge_{y2} befindet.

## Claims

1. A Method for forming a transistor on a semi-conductor on insulator type substrate comprising steps consisting in:
a) rendering amorphous and doping, by means of one or more localised implantation(s), of regions (121a, 123a) of blocks (121, 123) of crystalline semi-conductor material lying on an insulating layer (102) of the semi-conductor on insulator substrate and intended to form source and drain blocks arranged on either side of a zone (104) in which a channel of the transistor is intended to be formed, the implantation(s) being carried out so as to keep at the surface of said blocks (121, 123) a thickness of crystalline semi-conductor material on said given regions of semi-conductor material rendered amorphous, the amorphization and the doping being carried out at step a) by more than one step of implantation comprising in the following order or in the opposite order:
- an implantation by means of a non-doping species so as to render amorphous at least one portion of said given regions (121a, 123a),
- another implantation of a doping species so as to carry out an N-type or P-type doping of at least one portion of said given regions, this other implantation being carried out a temperature above a critical temperature above which said portion is not rendered amorphous by this other implantation,
b) recrystallization and activation annealing of the dopants of at least one portion of said given regions (121a, 123a).

2. The method according to claim 1, wherein at least one of said implantations at step a) is carried out using a beam inclined with respect to a normal to the principal plane of the substrate, such that said regions (121a, 123a) of semi-conductor material, rendered amorphous and doped, extend under insulating spacers (115a, 115b) situated on either side of a gate of the transistor situated opposite the channel zone.

3. The method according to any of the claims 1 or 2, wherein, at step b), a recrystallization and activation annealing of the dopants is carried out at a temperature below 600°C.

4. The method according to any of the claims 1 to 3, wherein, at step a), several implantations are carried out of which:
- at least one first implantation of doping species by means of a beam inclined according to a first angle α₁, such that α₁ > 0 with respect to a normal to the principal plane of the substrate,
- at least one second implantation by mean of a vertical beam or beam inclined according to a second angle α₂, such that 0 < α₂ ≤ α₁ with respect to a normal to the principal plane of the substrate.

5. The method according to any of the claims 1 to 4, further comprising, after step b): the formation of zones of alloy of semi-conductor material and metal from said semi-conductor blocks by:
- depositing metal material on the conserved thickness of crystalline semi-conductor material, then
- thermal annealing, at least one portion of the regions rendered amorphous at step a) being transformed into alloy of semi-conductor material and metal.

6. The method according to any of the claims 1 to 5, wherein the blocks (121, 123) of semi-conductor material are formed from a first layer based on Siₓ₁Ge_{y1}, surmounted by a second layer based on Siₓ₂Ge_{y2}, with 0 ≤ y₂ < y₁, the amorphization at step a) being carried out such that an interface between the crystalline semi-conductor material and the regions rendered amorphous is situated at an interface between the first layer based on Siₓ₁Ge_{y1}, and the second layer based on Si_{X2}Ge_{y2}.
